# EUROPEAN PATENT SPECIFICATION

(11) **EP 1 673 797 B1**
(45) Date of publication and mention of the grant of the patent: **09.12.2009**
(21) Application number: 04775184.7
(22) Date of filing: 06.10.2004
(51) Int. Cl.: H01J 37/244

(54) **DETECTOR SYSTEM OF SECONDARY AND BACKSCATTERED ELECTRONS FOR A SCANNING ELECTRON MICROSCOPE**
DETEKTORSYSTEM VON SEKUNDÄREN UND RÜCKGESTREUTEN ELEKTRONEN FÜR EIN RASTERELEKTRONENMIKROSKOP
SYSTEME DE DETECTION D'ELECTRONS SECONDAIRES ET RETRODIFFUSES POUR MICROSCOPE ELECTRONIQUE A BALAYAGE

(30) Priority: 14.10.2003 PL 36282603
(43) Date of publication of application: 28.06.2006
(73) Proprietor: POLITECHNIKA WROCLAWSKA, 50-370 Wroclaw (PL)
(72) Inventor: SLOWKO, Witold, PL-51-627 Wroclaw (PL)
(74) Representative: Gnatzig, Klaus
(86) International application number: PCT/PL2004/000078
(87) International publication number: WO 2005/036583

(56) References cited:
- EP-A- 0 767 482
- EP-A- 1 271 603
- WO-A-98/40906
- JP-A- 58 018 851
- US-B1- 6 590 210
- PATENT ABSTRACTS OF JAPAN vol. 1995, no. 08, 29 September 1995 (1995-09-29) -& JP 07 122220 A (HITACHI LTD), 12 May 1995 (1995-05-12)
- SLOWKO W: "Secondary electron detector with a micro-porous plate for environmental SEM" VACUUM, PERGAMON PRESS, GB, vol. 63, no. 4, 12 June 2000 (2000-06-12), pages 457-461, XP002268265 ISSN: 0042-207X

## Description

The subject of the invention is the detector system of secondary and backscattered electrons for a scanning electron microscope, destined particularly to work at pressures of order of 100 Pa in the sample chamber.

The secondary electron detector unit known from the patent applications: No PL329339, entitled "High pressure scanning electron microscope", now PL189008B1, and PL359748, entitled "Secondary electron detector unit for a scanning electron microscope", is composed of a microporous plate, of the micro sphere type advantageously, and a secondary electron detector of the scintillator type. In the both designs mentioned, a secondary electron stream is introduced to the hole in the lower vacuum wall, which is biased with a proper voltage. The hole constitutes the lower throttling aperture that limits gas flow from the sample chamber to the intermediate chamber. Secondary electrons that come into the intermediate chamber are directed toward the input surface of the microporous plate placed at the beam axis and are multiplied on their way through the plate. On the output side of the microporous plate, this amplified stream of the secondary electrons is attracted by the scintillator biased with a high voltage and is finally detected, i.e., it is converted into a light signal passing through the light pipe to the photo-multiplier to be converted into an electric signal once more.

A detector of the type described cannot detect backscattered electrons efficiently, because they have too high energies to be focused in the lower throttling aperture and get into the intermediate chamber. Thus, the output signal of the detector does not contain full information about the object, because backscattered electrons carry information of its material composition while secondary electrons give information of its topography.

A scanning electron microscope with a detector system according to the preamble of independent claim 1 is disclosed in SLOWKO W: "Secondary electron detector with a micro-porous plate for environmental SEM" VACUUM, PERGAMON PRESS, GB, vol. 63, no. 4, 12 June 2000 (2000-06-12), pages 457-461, XP002268265 ISSN: 0042-207X.

The subject of the invention is a scanning electron microscope with a detector system for secondary and backscattered electrons equipped with the microporous plate, a focusing electrode, and two scintillators connected with light pipes and a photomultiplier according to independent claim 1.

The matter of this arrangement consists in the fact, that the microporous plate is placed between the lower scintillator and the upper scintillator, where the lower scintillator is on the sample stage side. A movable diaphragm with a hole is located between the face of the photomultiplier and the ends of the upper and lower light pipe. Inside the intermediate chamber at least one focusing electrode is placed, with its hole positioned coaxially with the hole in the microporous plate
The focusing electrode is located advantageously on the lower scintillators surface.

The advantage of the described detector system of secondary and backscattered electrons for a scanning electron microscope is its capability of obtaining several signals with one detection unit, that means: the secondary electron signal, the backscattered electron signal, or the sum of signals mentioned above.

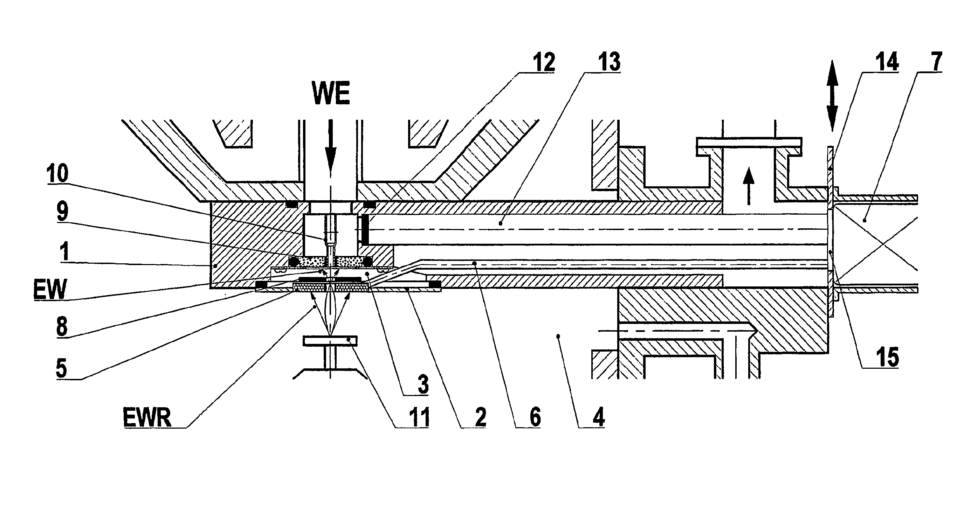

An example realization of the subject of this invention is illustrated on the Figure, which shows the detection system of secondary and backscattered electrons for a scanning electron microscope in cross-section.

The detection system of secondary and backscattered electrons for a scanning electron microscope is mounted in the head body 1, made of teflon. In the lower part of the head body 1 the vacuum wall 2 is located, which separates the interior of the head body 1 called the intermediate chamber 3 from the sample chamber 4 area. The lower scintillator 5 in the form of a plate with a small hole on the axis of the electron beam WE is attached to the vacuum wall 2. The lower scintillator 5 is connected to the lower light pipe 6 leading to the photomultiplier 7. The focusing electrode 8 having a hole placed axially with the electron beam WE is fixed above the lower scintillator 5, or on its upper surface. On the upper side of the intermediate chamber, the microporous plate 9 of micro-sphere type is fastened. It is sintered of tiny glass beads. The microporous plate 9 has a hole with the screen pipe 10 mounted inside, and placed axially with the electron beam WE, which allows the electron beam to pass to the sample stage 11. Over the microporous plate 9 the upper scintillator 12 is located, and connected with the upper light pipe 13 leading to the photomultiplier 7. The movable diaphragm 14 with the hole 15 is placed between the photomultiplier 7, and the ends of the upper light pipe 13 and the lower light pipe 6.

The operation of the secondary and backscattered electron detector system for a scanning electron microscope is explained below.

Backscattered electrons EWR generated from the specimen placed in the sample stage 11 are characterized by a high kinetic energy and rectilinear trajectories. Because of this, they strike on the surface of the lower scintillator 5, where they are converted to a corresponding light signal, which is transported by the lower light pipe 6 to the photomultiplier 7 and finally converted to an electric signal. The signal from this detection channel contains information about specimen composition. Alternatively the secondary electrons EW of small kinetic energies are accelerated and focused on the hole of the lower scintillator 5 by the electric field of the immersion lens. This field is created thanks to the bias voltage on three electrodes: the sample stage 11 and the surface of the lower scintillator 5 coated with a thin conducting layer, and the focusing electrode 8. The secondary electrons EW go further to the microporous plate 9, which acts like an electron multiplier and amplifies the electron signal. Then, the multiplied electrons are attracted by the upper scintillator 12 positively-biased with a high voltage, and are converted to a light signal which is transferred by the upper light pipe 13 to the photomultiplier 7, where it is finally converted to a corresponding electric signal. The signal of secondary electrons EW contains information about the examined surface topography. The movable diaphragm 14 located between the face of the photomultiplier 7 and the ends of the upper light pipe 13 and the lower light pipe 6, can be used to choose the type of signal reaching the photomultiplier 7. In the intermediate position the ends of the both light pipes fit in the hole 15 light, and signals created both by secondary electrons SE and backscattered electrons EWR are present at the photomultiplier 7. The image acquired with the sum of both signals is characterized by mixed topography and composition contrast. The proportion of both components can be adjusted by varying the microporous plate 9 bias voltage, which regulates the amplification of the secondary electron EW current passing through. Shifting the movable diaphragm 14 to opposite terminal positions results in masking the upper light guide 13 or lower light guide 6 alternatively. This allows obtaining images with dominating composition contrast or topography contrast.

## Claims

1. A scanning electron microscope for providing an electron beam (WE) said scanning electron microscope comprising, a sample chamber (4), a sample stage (11), and a detector system for secondary and backscattered electrons, wherein the detector system comprises an upper scintillator (12) connected with a light pipe (13) leading to said photomultiplier (7), a focussing electrode (8) and a microporous plate (9) acting as an electron multiplier wherein the upper scintillator (12) is positively biased with a high voltage to attract and accelerate electrons multiplied by said microporous plate (9) wherein, the detector system further comprises a head body (1) said head body being arranged in the sample chamber (4), said head body comprising an intermediated chamber (3) and a vaccum wall (2) separating the intermediate chamber (3) from the sample chamber (4) **characterised in that** the detector system further comprises a lower scintillator (5) connected with a light pipe (6) leading to said photomultiplier (7), that the lower scintillator (5) is arranged at the vacuum wall (2) at the side of the sample stage, and that the microporous plate (9) is arranged between the lower scintillator (5) and the upper scintillator (12).

2. The scanning electron microscope of claim 1, **characterized in that** the lower scintillator (5) is in the form of a plate with a small hole for the passage of an electron beam

3. The scanning electron microscope of claim 1 or 2, **characterized in that** the lower scintillator (5) is attached to the vacuum wall and that the microporous plate (9), the upper scintillator (12) and the focussing electrode (8) are arranged in the interior of said head body (1).

4. The scanning electron microscope of one of the claims 1 to 3, **characterized in that** the microporous plate (9) has a hole with a screen pipe (10) for the passage of the electron beam.

5. The scanning electron microscope of one of the claims 1 to 4 **characterized in that** a moveable diaphragm (14) with a hole (15) is arranged between the photomultiplier (7) and the ends of the light pipes (6, 13).

6. The scanning electron microscope of one of the claims 1 - 5, **characterized in that** the focussing electrode (8) has a hole which is arranged coaxially with a screen pipe (10) for the passage of the electron beam.

7. The scanning electron microscope of one of the claims 1-6 **characterized in that** the focussing electrode (8) is deposited on a surface of the lower scintillator (5)

8. The scanning electron microscope of one of the claims 1-7 **characterized in that** the microporous plate (9) is of the micro-sphere type.

## Patentansprüche

1. Rasterelektronenmikroskop zum Bereitstellen eines Elektronenstrahls (WE), wobei das Rasterelektronenmikroskop folgendes umfaßt: eine Probenkammer (4), eine Probenbühne (11), und ein Detektorsystem für sekundäre und rückgestreute Elektronen, wobei das Detektorsystem einen oberen Scintillator (12), der mit einem Lichtrohr (13) verbunden ist, das zu einem Photoelektronenvervielfacher (7) führt, eine Fokussierungselektrode (8) und eine mikroporöse Platte (9), die als ein Elektronenvervielfacher wirkt, umfaßt, wobei der obere Scintillator (12) mit einer Hochspannung positiv vorgespannt ist, um von der mikroporösen Platte (9) vervielfachte Elektronen anzuziehen und zu beschleunigen, wobei das Detektorsystem weiterhin einen Kopfkörper (1) umfaßt, wobei der Kopfkörper in der Probenkammer (4) angeordnet ist, wobei der Kopfkörper eine Zwischenkammer (3) und eine Vakuumwand (2), die die Zwischenkammer (3) von der Probenkammer (4) trennt, umfaßt, **dadurch gekennzeichnet, daß** das Detektorsystem weiterhin einen unteren Scintillator (5), der mit einem Lichtrohr (6) verbunden ist, das zu dem Photoelektronenvervielfacher (7) führt, umfaßt, daß der untere Scintillator (5) an der Vakuumwand (2) an der Seite der Probenbühne angeordnet ist und daß die mikroporöse Platte (9) zwischen dem unteren Scintillator (5) und dem oberen Scintillator (12) angeordnet ist.

2. Rasterelektronenmikroskop nach Anspruch 1, **dadurch gekennzeichnet, daß** der untere Scintillator (5) in der Form einer Platte mit einem kleinen Loch für den Durchtritt eines Elektronenstrahls vorliegt.

3. Rasterelektronenmikroskop nach Anspruch 1 oder 2, **dadurch gekennzeichnet, daß** der untere Scintillator (5) an der Vakuumwand angebracht ist und daß die mikroporöse Platte (9), der obere Scintillator (12) und die Fokussierungselektrode (8) im Inneren des Kopfkörpers (1) angeordnet sind.

4. Rasterelektronenmikroskop nach einem der Ansprüche 1 bis 3, **dadurch gekennzeichnet, daß** die mikroporöse Platte (9) ein Loch mit einem Siebrohr (10) für den Durchtritt des Elektronenstrahls aufweist.

5. Rasterelektronenmikroskop nach einem der Ansprüche 1 bis 4, **dadurch gekennzeichnet, daß** eine bewegliche Membran (14) mit einem Loch (15) zwischen dem Photoelektronenvervielfacher (7) und den Enden der Lichtrohre (6, 13) angeordnet ist.

6. Rasterelektronenmikroskop nach einem der Ansprüche 1-5, **dadurch gekennzeichnet, daß** die Fokussierungselektrode (8) ein Loch aufweist, das koaxial mit einem Siebrohr (10) für den Durchtritt des Elektronenstrahls angeordnet ist.

7. Rasterelektronenmikroskop nach einem der Ansprüche 1-6, **dadurch gekennzeichnet, daß** die Fokussierungselektrode (8) auf einer Oberfläche des unteren Scintillators (5) abgeschieden ist.

8. Rasterelektronenmikroskop nach einem der Ansprüche 1-7, **dadurch gekennzeichnet, daß** die mikroporöse Platte (9) vom Mikrokugeltyp ist.

## Revendications

1. Microscope électronique à balayage fournissant un faisceau d'électrons (WE), ledit microscope électronique à balayage comprenant une chambre d'échantillon (4), une platine d'échantillon (11) et un système de détection d'électrons secondaires et rétrodiffusés, dans lequel le système de détection comprend un scintillateur supérieur (12) connecté à un conduit de lumière (13) menant à un photomultiplicateur (7), une électrode de focalisation (8) et une plaque microporeuse (9) agissant comme multiplicateur d'électrons, dans lequel le scintillateur supérieur (12) est polarisé positivement par une haute tension pour attirer et accélérer des électrons multipliés par ladite plaque microporeuse (9), dans lequel le système de détection comprend de plus un corps de tête (1), ledit corps de tête étant disposé dans la chambre d'échantillon (4), ledit corps de tête comprenant une chambre intermédiaire (3) et une paroi à vide (2) séparant la chambre intermédiaire (3) de la chambre d'échantillon (4), **caractérisé en ce que** le système de détection comprend de plus un scintillateur inférieur (5) connecté à un conduit de lumière (6) menant audit photomultiplicateur (7), **en ce que** le scintillateur inférieur (5) est disposé sur la paroi à vide (2) du côté de la platine d'échantillon et **en ce que** la plaque microporeuse (9) est disposée entre le scintillateur inférieur (5) et le scintillateur supérieur (12).

2. Le microscope électronique à balayage de la revendication 1, **caractérisé en ce que** le scintillateur inférieur (5) est sous la forme d'une plaque avec un petit trou pour le passage d'un faisceau d'électrons.

3. Le microscope électronique à balayage de la revendication 1 ou 2, **caractérisé en ce que** le scintillateur inférieur (5) est fixé à la paroi à vide et **en ce que** la plaque microporeuse (9), le scintillateur supérieur (12) et l'électrode de focalisation (8) sont disposés à l'intérieur dudit corps de tête (1).

4. Le microscope électronique à balayage d'une des revendications 1 à 3, **caractérisé en ce que** la plaque microporeuse (9) a un trou avec un conduit d'écran (10) pour le passage du faisceau d'électrons.

5. Le microscope électronique à balayage d'une des revendications 1 à 4, **caractérisé en ce qu'**un diaphragme mobile (14) avec un trou (15) est disposé entre le photomultiplicateur (7) et les extrémités des conduits de lumière (6, 13).

6. Le microscope électronique à balayage d'une des revendications 1 - 5, **caractérisé en ce que** l'électrode de focalisation (8) a un trou qui est disposé de manière coaxiale avec un conduit d'écran (10) pour le passage du faisceau d'électrons.

7. Le microscope électronique à balayage d'une des revendications 1 - 6, **caractérisé en ce que** l'électrode de focalisation (8) est déposée sur une surface du scintillateur inférieur (5).

8. Le microscope électronique à balayage d'une des revendications 1 - 7, **caractérisé en ce que** la plaque microporeuse (9) est du type à microsphères.
